Europäisches Patentamt

European Patent Office

Office européen des brevets

(11) Publication number: **0 026 326**
**A1**

(12) # EUROPEAN PATENT APPLICATION

(21) Application number: 80105085.7

(22) Date of filing: 27.08.80

(51) Int. Cl.³: **H 03 K 3/78**
**H 03 K 5/15**

(30) Priority: 01.10.79 US 80873

(43) Date of publication of application:
08.04.81 Bulletin 81/14

(84) Designated Contracting States:
DE FR GB IT

(71) Applicant: International Business Machines
Corporation

Armonk, N.Y. 10504(US)

(72) Inventor: Parsons, Raymond Lonnie
3760 N. Tanuri Drive
Tucson, AZ 85715(US)

(72) Inventor: Paulsen, Paul Howard
1441 S. Perlman
Tucson, AZ 85710(US)

(74) Representative: Petersen, Richard Courtenay
IBM United Kingdom Patent Operations Hursley Park
Winchester Hants. SO21 2JN(GB)

(54) Timing interval generators and method of generation.

(57) Clock pulse plural cascade connected counters (SR1, SR2, SR3) generate a plurality of patterns. Upon each clock pulse, the patterns in the plurality of counters are captured in a like plurality of registers (22, 23, 24). Each of the captured counts are then compared with one or more bit masks for determining identity. Detection of identity between any one of the plurality of masks with the selected ones of the registers results in the emission of a timing pulse. The initial counter states and the various mask values in the mask sets for the respective registers are program loaded. The apparatus can be computer monitored or can be programmed within a digital computer. Accordingly, the timing intervals are programmable by selecting diverse time-out lists.

EP 0 026 326 A1

Croydon Printing Company Ltd.

BO9-77-054                                1

TIMING INTERVAL GENERATORS AND METHOD OF GENERATION


This invention relates to timing interval generators and methods of generation.  It is concerned with programmed timing control and more particularly the programmability of the time of occurrence of the pulse is generated by a combination of reference masks or patterns with a generated pattern.


In microprocessor controlled apparatus, requirements arise for the timing of events.  As microprocessor capability continually increases, the number of apparatus and the number of events controlled by a microprocessor greatly increase. Since many apparatus and processors have critical times for the initiation of diverse functions, requirements for generating timing pulses in an inexpensive and flexible manner has greatly increased.  The generation of such timing pulses should reach a minimal system cost by an astute collection of hardware and computer programming.  A timing pulse generation method for enabling such selections is needed in the microprocessor area.


Timing devices are known which measure a plurality of elapsed times; that is, a continuously running clock supplies timing signals to a plurality of memory devices which store the elapsed time on the occurrence of any of a plurality of events.  The respective memory is then latched to the time stored in memory.  In this manner, the time of event is accurately recorded.  This apparatus, however, does not provide for the selective gene ration of timing pulses, it only measures what has occurred.  It also does not provide for successive timed actuations via highly flexible programmable relationships.

BO9-77-054                              2

Computerised timers, of course, are known. External counters are known to be program loaded by a computer. In such apparatus, a clock drives the program loaded counter to zero which then interrupts the computer. This, however, requires one counter for each timing pulse. As the number of timing pulses required continually increases, this arrange ment becomes unduly expensive or on the other hand, to utilize that in a program, requires a lot of attention to the elapsed time of program execution. As programs are changed, such elapsed times can also change. Therefore, the maintenance and improvement of programs in such a situation becomes unduly burdensome.

Multiple timing in computerised systems includes measuring elapsed times of subroutines. This again, as in the first illustration, only measures actual elapsed time. It does not provide for flexible generation of timing pulses independent of other events.

It is an object of the present invention to provide a highly programmable and flexible timing pulse generator for generating a multiplicity of pulses, the times of occurrence of which are highly programmable.

In conjunction with the preceding object, it is another object of the invention to provide a method and apparatus for generation of multiple timing pulses which is easily programmable in a digital computer, easily implemented in hardware circuits or by a judiciously selected program and hardware combinations.

A multiple timing pulse generator includes a highly programmable timing interval generator which identifies a plurality of intervals by multi bit patterns, the elapsed time between successive ones of said multibit patterns being programmable. Upon the occurrence of a driving clock pulse, the then generated multiple multibit patterns are captured in a plurality of registers. The captured multibit patterns are then selectively compared with one or more mask sets. The number of masks in each set being selectable such that each series of multibit patterns can generate a programmable number of timing pulses. Upon a comparison of a mask in any mask set with the corresponding captured multibit pattern results in the generation of a timing pulse.

The method and apparatus of the invention can be employed in either hardware or programmed in a programmable unit such as a Neuman type computer, programmable logic array and the like.

According to the invention, a timing interval generator comprises means for generating clock pulses, plural interval means for defining a plurality of timing intervals, each of which is a multiple of the periodicity of the clock pulses, each interval means having a multibit set of signals indicative of a present interval, plural multibit register means for memorizing a last measured interval for each of the plural interval means, plural mask means for storing a plurality of multibit masks; and means for comparing the mask means with the register means, respectively, for detecting and indicating a mask-selected plurality of intervals.

The generator may include an oscillator - controlled means to generate a succession of clock pulses, a processor for executing programs of instructions, a memory attached to the processor for containing programs of instructions, the memory containing a series of programs of computer
instructions for enabling the processor to respond to the
clock pulses for generating a series of multibit patterns,
program means enabling the processor to capture a plurality
of the multibit patterns and separately memorize same for
each received clock pulse, and further program means for
comparing a plurality of multibit masks with the captured
multibit patterns and upon coincidence enabling the processor
to emit a time pulse.

The invention extends to a timer for generating a timing
signal in a succession of such timing signals when an event
occurrring in a computer is supposed to terminate or occur,
comprising a periodic pulse means for providing a recurring
sequence of pulses, storage means for storing indication of
the number of pulses that have occurred in the sequence, list
means for storing an indication of the length of time to time
out for a plurality of events occurring in a computer,
comparison means comparing the number of pulses stored in the
storage means with each length of time stored in the list
means and producing a timing signal indication each time
there is a concurrence of one of the lengths of times with
the number of pulses stored in the storage means.

The invention also encompasses a method of generating a
plurality of timing pulses, comprising the steps of:
generating a series of clock pulses for timing pulse
generation; generating a first multibit pattern from the
clock pulses; when the first multibit pattern reaches a
predetermined multibit pattern state supplying an output
timing pulse and generating a second multibit pattern from
the output timing pulse and repeating the number of multibit
pattern memorizing each and every multibit pattern that is generated, comparing each memorized multibit pattern with one
or more multibit masks for detecting coincidence, and for
each coincidence detected, supply a timing pulse such that a
series of timing pulses are generated in accordance with the
generated multibit patterns and the masks.

The scope of the invention is defined by the appended
claims; and how it can be carried into effect is hereinafter
particularly described with reference to the accompanying
drawings, in which :-

Figure 1 is a diagrammatic showing of a first
embodiment, of the present invention;

Figure 2 is a diagrammatic showing of an embodiment of
the invention; and

Figure 3 is a flow chart illustrating instruction level
steps for the embodiment of Fig.2.

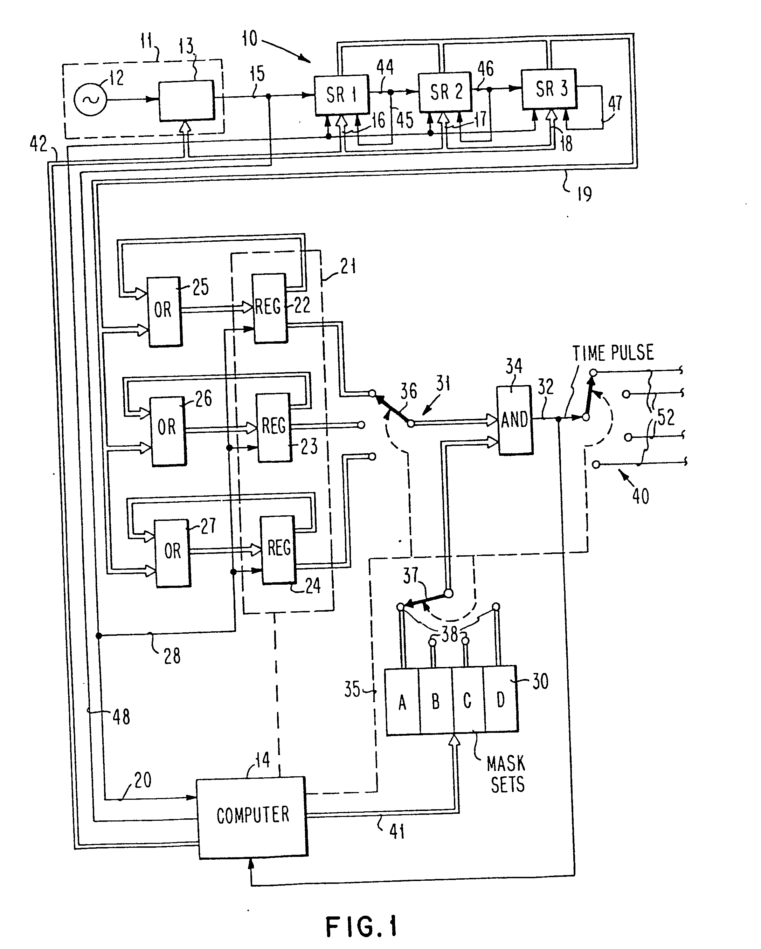

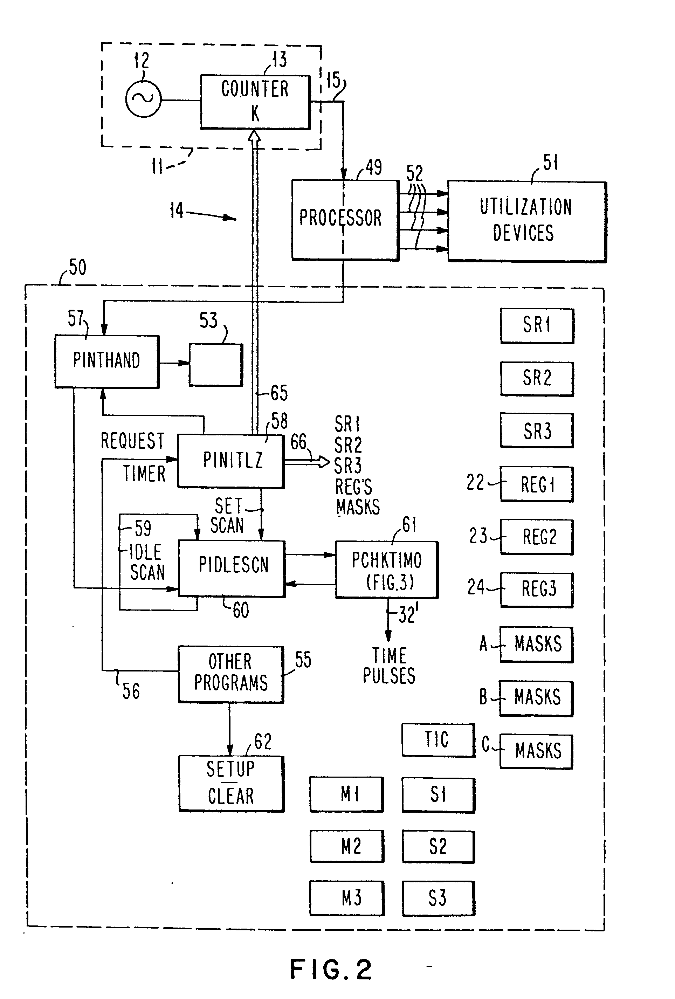

A multiple pulse timer (Fig.1) includes a shift register type
of multibit pattern generator 10 driven by a clock pulse
generator 11. Clock pulse generator 11 includes an
oscillator 12 supplying high frequency pulses to a counter
13. Counter 13 is loaded under program control of computer
14 which presents a number in the counter 13 over lines 65
(Fig.2) in cable 42. The counter 13 counts incoming pulses
from the oscillator 12 and issues a clock pulse on line 15
when the count reaches the preset number. This determines
the frequency of pulses supplied on line 15. Multibit
pattern generator 10 includes three shift registers SR1, SR2
and SR3, which contains a multibit pattern indicative of
elapsed time as measured by the number of pulses on line 15.

The elapsed time is indicated by the product of the change in pattern from the initial pattern in the shift registers (which is a measure of clock pulses received) and the time interval between clock pulses on line 15. Shift registers SR1, SR2, SR3 are initially loaded by computer 14 over lines 16, 17 and 18, respectively, in cable 42. In a simple pattern, one selected bit position in each of the registers SR1, SR2, SR3 is set to unity.

Each time the generator 11 issues a clock pulse on line 15, computer 14 also receives the pulse over line 20. Simultaneously, multibit pattern storage means 21 receives and stores the multibit patterns then in shift registers SR1, SR2 and SR3. Storage means 21 consists of three multibit registers 22, 23, and 24 which receive the multibit patterns through multi-element OR circuits 25, 26, and 27, respectively from shift registers SR1, SR2, and SR3. The clock pulse on line 15 is also supplied over line 28 to enable registers 22, 23, and 24 to receive the signals from the three shift registers. The OR circuits 25, 26, and 27 combine the multibit pattern in an OR logic function with the present pattern in the respective register. In this manner, successive patterns represent pulses accumulated in the respective registers. Dispensing with the logic OR circuits 25, 26, and 27 adds additional flexibility in that the multibit patterns are not cumulative but are generated in the three shift registers SR1, SR2 and SR3. The registers 22, 23 and 24 are cleared each time ready to receive the next patterns from the generator 10. The electrical connections between the shift registers and the OR circuits are direct and individual; i.e., the connections are not over a common bus. The single cable 19 (Fig.1) includes all the individual connections.

Each time the computer 14 receives the interrupt signal in the form of a clock pulse over line 20, it programmably controls the comparison of the multibit patterns in registers 22, 23 and 24 with a plurality of multibit masks stored in a memory 30 as sets of masks. Under computer control, the multibit masks are fetched from memory 30 and serially supplied to multibit comparator 31. The multibit masks are compared in turn with the patterns stored in registers 22, 23 and 24 for generating a time pulse over line 32 upon coincidence of patterns and masks. The time pulse on line 32 is supplied to utilization means (not shown) on one of lines 52 selected by a computer controlled switch 40, as well as to computer 14.

Comparator 31 includes electronic circuits represented by the diagrammatic symbols of switches 36 and 37. Switches 36 and 37 scan registers 22, 23 and 24 synchronously with registers in memory 30 using known scanning techniques. A multiple AND circuit 34 does the actual comparison and generation of time pulses. Computer 14 supplies scan control signals over a plurality of lines 35 to actuate the pair of scanning switches 36 and 37 and switch 40. Scanning switch 36 scans registers 22, 23 and 24 to supply the multibit patterns for comparison by AND circuits 34. Switch 37 in turn selects which multibit mask set is to supply a multibit mask for comparison with the selected multibit pattern. Internal to memory 30, under computer control, the multibit masks in each of the sets are supplied serially to the respective terminals 38 of scanning switch 37. As shown, switch 36 is set to receive the multibit pattern from register 22 and compare it to a multibit mask from mask set A under computer scanning control. If the pattern in register 22 satisfies one of the masks of set A, and the patterns in registers 23 and 24 satisfy one of the masks of sets B and C, respectively, the AND circuits 34 will be satisfied and issue a time pulse on line 32. . The pulse on line 32 informs computer 14 a time out has occurred and a time pulse has been generated. Then computer 14 may want to alter position of switch 40 to supply the next timing pulse over a different line. Switch 40 is, of course, an electronic switch.

Computer 14 then actuates switches 36 and 37 in either a serial or random manner until all of the multibit masks in memory 30 have been used in comparison with one or more of the multibit patterns in registers 22, 23 and 24. For example, there may be three multibit masks in set A, two in set B, two in set C and three in set D. Under computer control, the certain timing operation may require the patterns of sets C and D or only C, but not D. Accordingly, depending upon the process or process portion being controlled, the mask sets can be substituted for each other for programming different series of time pulses. Also at the beginning of each timing cycle, computer 14 supplies a set of multibit masks over cable 41 to memory 30 for use in subsequent timing operations. At times selected by computer 14, the initial multibit patterns are supplied over cables 16, 17 and 18 to the three shift registers SR1, SR2 and SR3 and over cable 42 to counter 13. Accordingly, each cycle of the time can be programmed to perform different timing generations or the timing generation can be completely the same over a series of repetitions.

Turning now to multibit pattern generator 10, the clock pulses on line 15 actuate SR1 to shift one position. In a most simple embodiment, SR1 will contain a single binary one with the rest 0's. When the single 1 has been shifted through the bit positions of SR1, a pulse signal is supplied as a carry signal over line 44 which is then re-entered to SR1 in the lowest digit position over line 45 to be shifted again by the flow of clock pulses on line 15. The signal on line 44 travels to SR2 to act as a clock pulse for that shift register. Therefore, SR2 shifts one each time SR1 shifts through its cycle; however, the cycling of SR2 can be increased by placing two ones in SR1. For example, if SR1 is a 4-bit register, two ones are placed in the first and third position. The logical effect of this is to reduce the length of SR1 to two bits. SR2 operates identically to SR1 and supplies a carry signal over line 46 to shift SR3 one position and to re-enter SR2. Therefore, SR3 is shifted once each time SR2 shifts through its cycle. SR3 in turn supplies a carry signal over line 47 which is re-entered to SR3 at the end of its cycle. Without intervention of computer 14, multibit patterns of SR1, SR2 and SR3 would cycle indefinitely. Therefore, one of the patterns in SR3 can be used as a stop pattern for stopping the timing cycle, if that is desired. The comparator 31, after each clock pulse on line 15, checks the pattern in 24 against a timing cycle stop pattern mask set in memory 30. Differing timings require different shift register lengths as well as different number of shift registers. The shift registers can have different numbers of bits.

Computer 14 also supplies an enabling signal over line 48 to SR1, SR2 and SR3 for gating the initial patterns over the lines 16, 17 and 18 to the shift registers before the shifting operations. By making line 48 three lines and timing the operation of those three lines, the intervals of SR1, SR2 and SR3 can be programmably changed during the cycle. However, the timing generation of this very programmable system would rarely require such intervention by the computer although it is capable of doing so.

As mentioned above, each of the shift registers would have at least single bit for generating successively increasing time intervals. The shift registers can be constructed as a linear feedback shift register wherein complex patterns are generated with the clocking output signals on lines 44, 46 and 47 being taken from one or more of the stages in such a linear feedback register. Other configurations can also be envisaged. In any event, the multibit patterns generated by generator 10 are timed dependent on the timing of pulses on line 15 and the initial patterns in the three shift registers as well as the constructional features of those registers. Those program multibit patterns are then compared with the program multibit mask for yielding an ultimate in flexible timing pulse generation.

Figure 2 illustrates a microprocessor programmed equivalent of the Figure 1 illustrated embodiment. While all the elements are program elements, clock 11 supplies its pulses over line 15 to processor 49 of computer 14 for interrupting same, as is well known. Processor 49 is connected to utilization devices 51 via a plurality of lines 52 corresponding to the output lines from switch 40 (Fig. 1). Computer 14 not only includes processor 49 but memory 50, such as any random access memory, containing a set of computer programs of instructions and memory registers for containing constants and operands. The operation of processor 49 with memory 50 is well known and not further described for that reason.

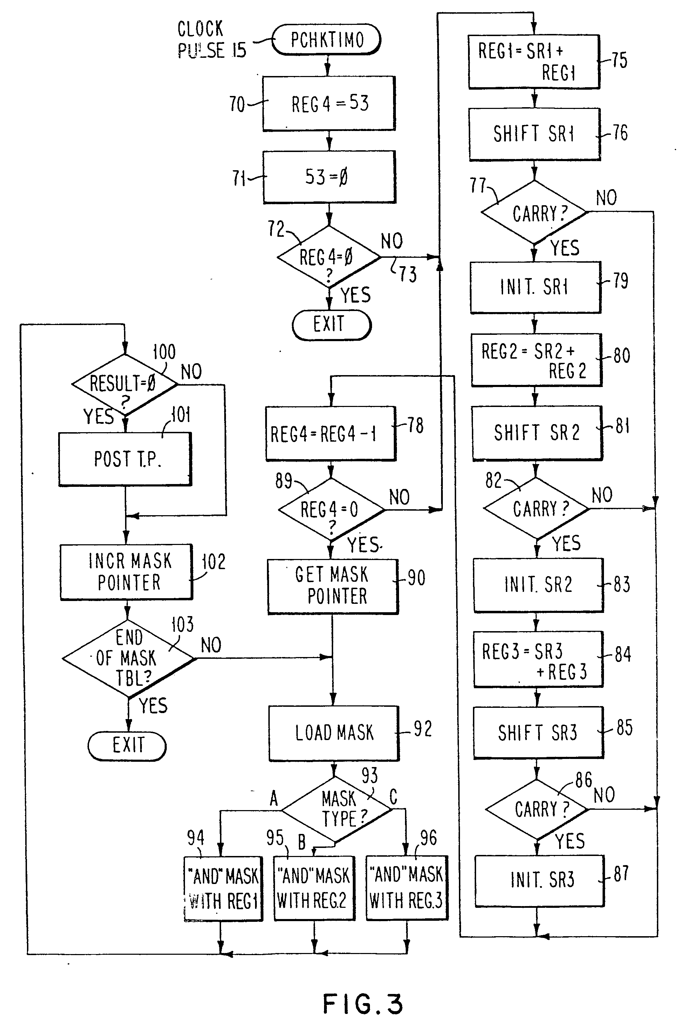

In general, the computer 14 operates on a relatively large set of computer programs of instructions, as designated by numeral 55. Such programs can include sequences of computer functions which are used for controlling numerically controlled machines, computer peripheral equipment, chemical processes, vehicles of all types and the like. Many of these programs when in a machine controlled environment utilize sets of control effecting timing pulses. To set up a timing sequence, a request for the timer is issued via a branch instruction diagrammatically represented by line 56 which is to request a timer operation. In a programmed embodiment counter 53 is represented by a memory register controlled by the processor 49 utilizing computer program PINTHAND 57. This program is enabled by an initialize routine PINITLZ 58. Program 58 initializes the three shift registers SR1, SR2 and SR3, the three multibit pattern registers 22, 23 and 24, and all of the multibit masks in sets A, B and C. Idle scan program loop 59 includes short subroutine PIDLESCN 60, a sub-routine that initiates operation in the computer to practice the present invention. Idle scan program loop 59 is a routine which enables processor 49 to scan for work; therefore, insertion of routine 60 into the idle scan loop 59 is the mechanism for referring to the sequences of computer program instructions that implement the invention. Routine 60 calls program sequence 61 PCHKTIMO 61, (Fig. 3). When processor 49 executes PCHKTIMO, it can emit time pulses over lines 52 to utilization devices 51. Such pulse generation, as described later with respect to Figure 3, is indicated by line 32 which represents a timing flag set within the memory 50. Another program such as a program of other programs 55 senses the flag for generating the pulse using well known program control and outputting techniques.

In addition to all of the above, it is desired to have a flexible setup for adjusting the timing operation. Along these lines, program 62 provides setup and clear functions for introducing time delays, and clearing out time delays, inserting a location where timing pulses should be emitted, such as by adding a mask, deleting timing pulses by deleting a mask and the like. Since setting up tables and the like are well known in the computer arts, and their understanding of the set up routine and clear routine 62 is not germane to the understanding of the invention, further discussion is dispensed with.

The request timer instruction 56 invokes program 58 PINITLZ for initializing timer operation. In the simple embodiment wherein the three shift registers are 4-bit registers and act as cascaded counters, program 58 merely inserts a 1000 pattern in each of the shift registers. Registers 22, 23 and 24 are set to 0. Mask sets A, B and C receive selected mask patterns respectively from registers M1, M2 and M3 which have received bit patterns, via program 62. As mentioned for the Fig.1 illustrated embodiment, several multibit masks may reside in each of the sets A, B and C. Similarly, registers S1, S2 and S3 contain arbitrary patterns for presetting shift registers SR1, SR2 and SR3. The program 62 selects the patterns actually inserted from those in registers S1, S2 and S3. Further, register TIC contains a number to determine the length of count of counter 13. Program 58 loads counter 13 as over cable 65 whereas the other registers are loaded via cable 66, both cables representing a series of program steps. In a practical embodiment, interrupt masking, program status, and so forth are involved in all of the programming. However, for purposes of simplicity and understanding, such well known computer program techniques have been omitted from the above description. It is seen that program 58 merely acts as a reference table and inserts multibit patterns into the registers associated with the programs implementing the timing functions. For that reason, program 58 is not described.

Program 58 also sets a bit for enabling program 57 to respond to clock pulses on line 15 to invoke PCHKTIMO 61 via PIDLESCN 60.

PIDLESCN 60 merely consists of a branch and return instruction for sensing clock pulses on line 15 detected by the program 57. The set scan branches to an instruction which calls PCHKTIMO 61. Thus, each time the program 57 detects a clock pulse on line 15, it initiates PCHKTIMO 61 through PIDLESCN 60. When PCHKTIMO 61 finishes, the processor 49 returns to PIDLESCN 60 and thence to idle scan 59. PINTHAND counts clock pulses on line 15 in counter 53. The number in counter 53 is compared by execution of PCHTIMO 61, as described with respect to Fig.3. Fig.3 is an instruction level flow chart representative of the computer program instructions in routine 61. The first instruction 70 causes processor 49 to fetch the contents of counter 53 and store the contents in work register 4 in processor 49. Instruction 72 is used only to initialise the counter 53 under program control. Then at instruction 72, processor 49 checks the contents of work register 4. If it is 0, timing sequences have been completed or no timing is currently being performed; processor 49 then exits returning to PIDLESCN 60. At this point also, a flag can be set for informing other programs 55 that the timing sequence requested by instruction 56 has been completed. When counter 53 has a non-zero count, processor 49 follows program path 73 to a re-entrant program
counting loop performing the function of multibit pattern bit
generator 10 (Fig.1) and memory means 21 (Fig.1).  The
counting loop (Fig.3) performs a timing function by
downcounting the value in register 4 from that in counter 53
to 0 in instruction 78 with the number of instructions in the
loop determining the elapsed time.  Therefore, the counting
loop upon receiving a request pulse from PINTHAND 57 times
through a series of pulse generating instructions as the
pulses were generated by SR1, SR2 and SR3 of Fig.1, each
series being initiated by a clock pulse on line 15.

Instruction 75 ORs the contents of shift register SR1
into register 22 (REG 1) and stores the result in register
22.  This action corresponds to the Fig.1 updating of its
register 22.  Then the signal contents of SR1 are shifted by
processor 49 via instruction 76.  Branch instruction 77
enables processor 49 to check for a SR1 carry which
corresponds to te Fig.1 carry at line 44.  In most processors
including processor 49, the shift instruction can generate a
carry in an arithmetic logic unit (ALU) (not shown) which
enables processor 49 via instruction 77 to check for the
carry.  If there is no carry, then the counting sequence
stops.  With a carry, the counting sequence also includes
execution of further instructions.

The count in register 4 is decremented by procesor 49 at
instruction 78.  Then instruction 89 checks for register 4
contents equalling zero.  If not zero, instruction 75 is
again executed to initiate more counting.

Instructions 79 to 82 correspond to SR2 of Fig.1.
Instruction 79 resets SR1 of Fig.2 to its initial value.

Instruction 80 ORs the contents of SR2 with the contents of
register 23 with the results sotred in register 23.  The
contents of SR2 are shifted at 81 with the carry sensed at
82.  If there is no carry, then instruction 78 is executed.

When a carry is detected at instruction 82, the contents
of SR2 are initialized to the original value by instructon
83.  Then the signal contents of SR3 are logically ORed with
register 24 and stored in register 24, all by instruction
84.  Then the signal contents of SR3 are shifted at 85 and
carry checked at 86.  If no carry, instruction 78 is again
executed.  With a carry at 86, SR3 is initialized to its
original value and instruction 78 is then executed.

On counting sequence loop may include several iterations
of these instruction loops, the instruction 78 being followed
by branch instruction 89, which if not satisfied returns to
instruction 75.

The above described counting loop is repeated until the
content of work register 4 is zero as determined by branch
instruction 89.  Pulse generation activities corresponding to
operation of circuit 31 of Fig.1 then begin.  First at 90,
mask pointer for a mask is obtained.  The mask (a bit
pattern) is loaded into processor 49 at instruction 92.  The
mask type or set is checked at 93.  According to which type
or set is identified, the masks are ANDed in turn with the
contents of register 22, 23 or 24 in instructions 94, 95 or
96.  The mask-count compare (same as AND circuit 34 of Fig.1)
at 94, 95 and 96 is made and the result checked at branch
instruction 100 for equality.

If there is a compare equality at 100, then at 101, a time pulse is posted corresponding to line 32$'$ to be used by an output routine (not shown but in other programs 55) to generate a pulse on a line 52. Then the number of output pulses that have been generated can be tallied and stored. The routine passes to instruction 102 which increments the mask pointer count and is followed by a branch instruction 103, where it is determined whether the end of the mask table has been reached. If not, instruction 92 follows and the loop is repeated. This pulse generating loop is repeated until all checks have been made as indicated by the end of the mask table, instruction 103.

If there is at instruction 100 inequality, then there is no pulse to be generated and instructions 102, 103, 92, 93 and 94, 95 or 96 are repeated until all time outs have been checked. This sequence is determined by the number of masks to be checked.

While the invention has been particularly shown and described with reference to preferred embodiments thereof, it will be understood by those skilled in the art that various changes in form and detail may be made therein without departing from the scope of the invention.

CLAIMS


1       A timing interval generator comprising means (11) for generating clock pulses, plural interval means (SR1, SR2, SR3) for defining a plurality of timing intervals, each of which is a multiple of the periodicity of the clock pulses, each interval means having a multibit set of signals indicative of a present interval, plural multibit register means (22, 23, 24) for memorizing a last measured interval for each of the plural interval means, plural mask means (30) for storing a plurality of multibit masks; and means (34) for comparing the mask means with the register means, respectively, for detecting and indicating a mask-selected plurality of intervals.

2       A generator according to claim 1, in which the plural interval means include a plurality of cascade connected multibit shift registers, a first shift register (SR1) receiving clock pulses and emitting a carry pulse when a 1 bit has reached a predetermined position in the first shift register, a second shift register (SR2) receiving the carry pulse as an input shift pulse and in turn having a carry output for applying a shift pulse to a next succeeding shift register (SR3), and each of the shift registers individually containing a multibit pattern and supplying same to the plural multibit register means (22, 23, 24).

3       A generator according to claim 1 or 2, in which the compare means includes plural scanning means (36) for scanning the plural multibit register means for fetching multibit patterns in a predetermined sequence, and further scanning means (37) operatively associated with the plural mask means for scanning the plural mask means for fetching multibit mask patterns, means for coincidentally receiving
the fetched multibit patterns and multibit mask patterns in
the sequence and checking for coincidence and supplying an
indication upon detection of such incidence, and means
responsive to such indication to supply a time pulse.

4     A generator according to claim 3, in which the plural
mask means includes a plurality of multibit masks for each of
the plural multibit register means, and the scanning means
including means for scanning a plurality of multibit masks
for each multibit pattern stored in each of the plural
multibit registers.

5     A generator according to claim 1 and adapted to be
connected to a programmed digital computer, comprising input
output means connecting the computer to the means for
generating clock pulses for supplying bit patterns for
determining an interval of the clock pulses, means connecting
the computer to the plural interval means for transferring
multibit patterns to the plural interval means, respectively,
for defining duration of the plurality of timing intervals,
means connecting the computer to the plural mask means for
transferring a plurality of multibit mask sets of signals to
the plural mask means for determining intervals between
successive time pulses, and input means in the computer
connected to the compare means for receiving the time pulses.

6     A timing interval generator including an oscillator -
controlled means (11) to generate a succession of clock
pulses, a processor (49) for executing programs of
instructions, a memory (50) attached to the processor for
containing programs of instructions, the memory containing a
series of programs of computer instructions for enabling the
processor to respond to the clock pulses for generating a
series of multibit patterns, program means enabling the processor to capture a plurality of the multibit patterns and separately memorize same for each received clock pulse, and further program means for comparing a plurality of multibit masks with the captured multibit patterns and upon coincidence enabling the processor to emit a time pulse.

7      A timer for generating a timing signal in a succession of such timing signal when an event occurring in a computer is supposed to terminate or occur, comprising a periodic pulse means (11) for providing a recurring sequence of pulses, storage means (SR1, SR2, SR3) for storing indication of the number of pulses that have occurred in the sequence, list means (M1, M2, M3) for storing an indication of the length of time to time out for a plurality of events occurring in a computer, comparison means comparing the number of pulses stored in the storage means with each length of time stored in the list means and producing a timing signal indication each time there is a concurrence of one of the lengths of times with the number of pulses stored in the storage means.

8      A timer according to claim 7, which the storage means and the list means are storage registers which comprises a plurality of stages each representing one pulse produced by the periodic pulse means and are ordered in order of increasing number of pulses and the comparison means includes a plurality of two input AND circuits each receiving one input from like ordered stages of the storage means and the list means.

9      A method of generating a plurality of timing pulses, comprising the steps of: generating a series of clock pulses for timing pulse generation; generating a first multibit pattern from the clock pulses; when the first multibit pattern reaches a predetermined multibit pattern state supplying an output timing pulse and generating a second
multibit pattern from the output timing pulse and repeating
the number of multibit pattern generation up through a
predetermined number of patterns, each time a clock pulse is
supplied for the first multibit pattern memorizing each and
every multibit pattern that is generated, comparing each
memorized multibit pattern with one or more multibit masks
for detecting coincidence, and for each coincidence detected,
supply a timing pulse such that a series of timing pulses are
generated in accordance with the generated multibit patterns
and the masks.

10    A method according to claim 9, further including
setting a plurality of patterns in the multibit pattern
generators for altering the generated timing intervals
independent of the multibit masks.

11    A method according to claim 9 or 10, including altering
the multibit masks independent of the plural multibit
patterns for altering the interval of the timing pulses being
generated.

FIG.1

FIG.2

3/3

FIG.3

0026326

<table>
<tr><td rowspan="2"><strong>European Patent Office</strong></td><td rowspan="2" align="center"><strong>EUROPEAN SEARCH REPORT</strong></td><td>Application number</td></tr>
<tr><td>EP 80 10 5085</td></tr>
</table>

| | **DOCUMENTS CONSIDERED TO BE RELEVANT** | | CLASSIFICATION OF THE APPLICATION (Int Cl.³) |
|---|---|---|---|
| Category | Citation of document with indication, where appropriate, of relevant passages | Relevant to claim | |
| | <u>US - A - 4 101 761</u> (MERRYMAN)<br>  * Figure 2; column 3, line 52 to column 4, line 20 *<br><br>-- | 1,3,4,<br>6-9,11 | H 03 K   3/78<br>          5/15 |
| | <u>FR - A - 2 155 311</u> (ZELLWEGER)<br>  * Figure; page 3, line 27 to page 7, line 15 *<br>& US - A - 3 772 659<br><br>-- | 1,3-6,<br>8-11 | |
| | <u>US - A - 3 621 403</u> (SEIY)<br>  * Figure 1; column 1, line 70 to column 3, line 29 *<br><br>-- | 1-5,7,<br>9,11 | TECHNICAL FIELDS SEARCHED (Int. Cl.³)<br><br>H 03 K   3/78<br>          5/15<br>          5/13<br>G 06 F   1/04 |
| | IEEE TRANSACTIONS ON INDUSTRIAL ELECTRONICS AND CONTROL INSTRU-MENTATION, vol. IECI-25,<br>no. 1, February  1978.<br>New York, US<br>SAINT-HILAIRE et al. "A programmable multichannel-output pulse train generator for direct digital control", pages 3-10.<br>  * Figures 1,2,4; page 3, left-hand column, last paragraph to page 4, left-hand column, third paragraph *<br><br>-- | 1,3-5,<br>7-9,11 | |
| | IBM TECHNICAL DISCLOSURE BULLETIN, vol. 11, no. 8, January 1969,<br>New York, US<br>HOLMSTROM: "Programmable time base generator", pages 959-960.<br>  * Figure; pages 959-960 *<br><br>--                    ./. | 1,5,6 | CATEGORY OF CITED DOCUMENTS<br><br>X: particularly relevant<br>A: technological background<br>O: non-written disclosure<br>P: intermediate document<br>T: theory or principle underlying the invention<br>E: conflicting application<br>D: document cited in the application<br>L: citation for other reasons<br><br>&: member of the same patent family, corresponding document |

| | | |
|---|---|---|
| The present search report has been drawn up for all claims | | |
| Place of search<br>The Hague | Date of completion of the search<br>07-01-1981 | Examiner<br>LEDRUT |

EPO Form 1503.1  06.78

## EUROPEAN SEARCH REPORT

**European Patent Office**

| | DOCUMENTS CONSIDERED TO BE RELEVANT | | CLASSIFICATION OF THE APPLICATION (Int. Cl. ³) |
|---|---|---|---|
| Category | Citation of document with indication, where appropriate, of relevant passages | Relevant to claim | |
| | FR - A - 2 252 702 (TELEFONAKTIE-BOLAGET ERICSSON) <br><br> * Figure; page 2, line 26 to page 3, line 24 * <br><br> & US - A - 3 944 858 <br><br>   -- <br><br> DE - B - 1 219 983 (LICENTIA) <br><br> * Figure 1; column 3, line 6 to column 4 * <br><br>   ---- | 1,3,5, 7,9 <br><br><br><br><br><br> 1,8 | |
| | | | **TECHNICAL FIELDS SEARCHED (Int. Cl. ³)** |

EPO Form 1503.2   06.78